# EUROPEAN PATENT APPLICATION

(11) **EP 4 800 400 A1**
(43) Date of publication of application: **02.09.2026**
(21) Application number: 26160811.1
(22) Date of filing: 25.02.2026
(51) Int. Cl.: G01R 1/20, G01R 31/28, H05B 6/12

(54) **ADAPTIVE CHARACTERIZATION PROCESS FOR INDUCTION COOKTOP SYSTEM**

(30) Priority: 26.02.2025 US 202519064145
(71) Applicant: Whirlpool Corporation, Benton Harbor, MI 49022 (US)
(72) Inventor: CLIPCA, Constantin, Benton Harbor, 49022 (US); GALLIVANONI, Andrea, Benton Harbor, 49022 (US); BARBATI, Mario, Benton Harbor, 49022 (US); BALDO, Salvatore, Benton Harbor, 49022 (US)
(74) Representative: Murgitroyd & Company

(57) **Abstract**

A method for estimating coil current for an inductive cooking appliance may include receiving a multiplicity of measured voltage drops for each of a predetermined inverter period across a shunt resistor arranged on a low side of an inverter, extract at least one of a root mean square (RMS) and a peak voltage for the multiplicity of voltage drops received during a predetermined inverter period, and determine a coil current based on the extracted at least one of the RMS and peak voltages.

## Description

### CROSS-REFERENCE TO RELATED APPLICATIONS

This application claims priority to U.S. Patent Application Serial No. 19/064,145 filed on February 26, 2025, the disclosure of which is hereby incorporated in its entirety by reference herein.

### TECHNICAL FIELD

Disclosed herein are adaptive characterization process for induction cooktop system.

### BACKGROUND

Induction cooking appliances use induction coils to heat items directly. For instance, the induction coils may directly heat pots and pans through magnetic induction. An electric current is passed through the coil underneath the surface, creating a magnetic field and then a current throughout the pot or pan above that produces heat. As opposed to other types of cooking appliances, the surface of induction cooking appliances stays relatively cool while maintaining a consistent temperature on pots and pans and delivering power with a higher efficiency.

### SUMMARY

A method for estimating coil current for an inductive cooking appliance may include receiving a multiplicity of measured voltage drops for each of a predetermined inverter period across a shunt resistor arranged on a low side of an inverter, extract at least one of a root mean square (RMS) and a peak voltage for the multiplicity of voltage drops received during a predetermined inverter period, and determine a coil current based on the extracted at least one of the RMS and peak voltages.

Optionally, the method includes determining a multiplicity of sample current signal based on the multiplicity of voltage drops.

Optionally, the method includes calculating an average power based on the inverter period and/or the multiplicity of sample current signals and/or a time slot and/or a load voltage.

Optionally, the time slot is a predefined time interval larger than the inverter period.

Optionally, the load voltage is voltage drop across a resonant tank connected to the inverter.

Optionally, the extracted at least one of the RMS and peak voltages is achieved via signal processing.

Optionally, the method includes synchronizing the first sample of the multiplicity of sample current signal with a predefined time difference relative to an end of an inverter half-period.

Optionally, the predefined time difference can be one of positive or negative.

Optionally, the method includes substituting a first sample current signal with a later acquired sample current signal.

Optionally, the method includes interpolating at least one of the samples in the multiplicity of sample current signal, excluding the substituted sample current signal, using at least the substituted sample current signal.

Optionally, the method includes reconstructing the measured and estimated signals in a second half-period based on signal symmetry with a first half-period through the inverter.

A system for estimating coil current for an inductive cooking appliance may include an inverter having a high side and a low side, a shunt resistor arranged on a low sides of the inverter, a resonant tank connected to the inverter, a controller programmed to receive a multiplicity of measured voltage drops for each of a predetermined inverter period time slot across a shunt resistor arranged on a low side of an inverter, extract at least one of a root mean square (RMS) and a peak voltage for the multiplicity of voltage drops received during a predetermined inverter period each received voltage drop, and determine a coil current based on the extracted at least one of the RMS and peak voltages.

Optionally, the controller is further programmed to determine a multiplicity of sample current signal based on the multiplicity of voltage drops.

Optionally, the controller is further programmed to calculate an average power based on the inverter period and/or the multiplicity of sample current signals and/or a time slot and/or a load voltage,

Optionally, the extracted at least one of the RMS and peak voltages is achieved via signal processing.

Optionally, the controller is further programmed to determine a sample current signal based on the voltage drop.

Optionally, the controller is further programmed to synchronize a first sample of the multiplicity of sample current signal with a predefined time difference relative to an end of an inverter half-period.

Optionally, the controller is further programmed to substitute the first sample current signal with a later acquired sample current signal.

Optionally, the controller is further programmed to interpolate at least one of the samples in the multiplicity of sample current signal, excluding the substituted sample current signal, using at least the substituted sample current signal.

Optionally, the controller is further programmed to reconstruct the measured and estimated signals in a second half-period based on signal symmetry with a first half-period through the inverter.

### BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompanying drawings in which:
FIG. 1 illustrates a side view of an induction cooking system;
FIG. 2 illustrates an example full bridge inverter having a shunt resistor;
FIG. 3 illustrates the time slots division of the entire coil current ;
FIG. 4 illustrates one inverter period inside one sampled time slots ;
FIG. 5A illustrates an example current measurement and reconstructed current before and after substitution of the initial samples;
FIG. 5B illustrates example current measurements and reconstructed current before and after interpolation;
FIG. 6 illustrates a comparison between a measured coil current and the reconstructed signal interpolated from the samples and post processing;
FIG. 7 illustrates a segmented period of *V_{bus}*;
FIG. 8 illustrates an example circuit board having two cooking areas;
FIGs. 9A-E illustrates example circuit signals where the phase shift is 90 degrees between the PWM signals of S₁ and S₂, or S₃ and S₄, where:

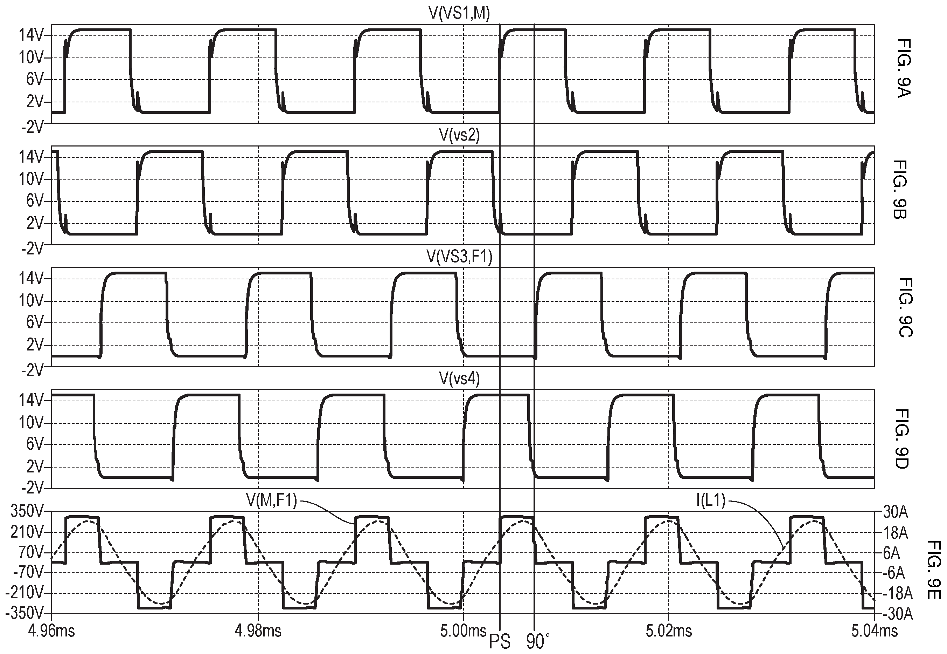

FIG. 9A illustrates a gate signal of S₁;
FIG. 9B illustrates a gate signal of S₂;
FIG. 9C illustrates a gate signal of S₃;
FIG. 9D illustrates a gate signal of S₄;
FIG. 9E illustrates a voltage load and coil current;

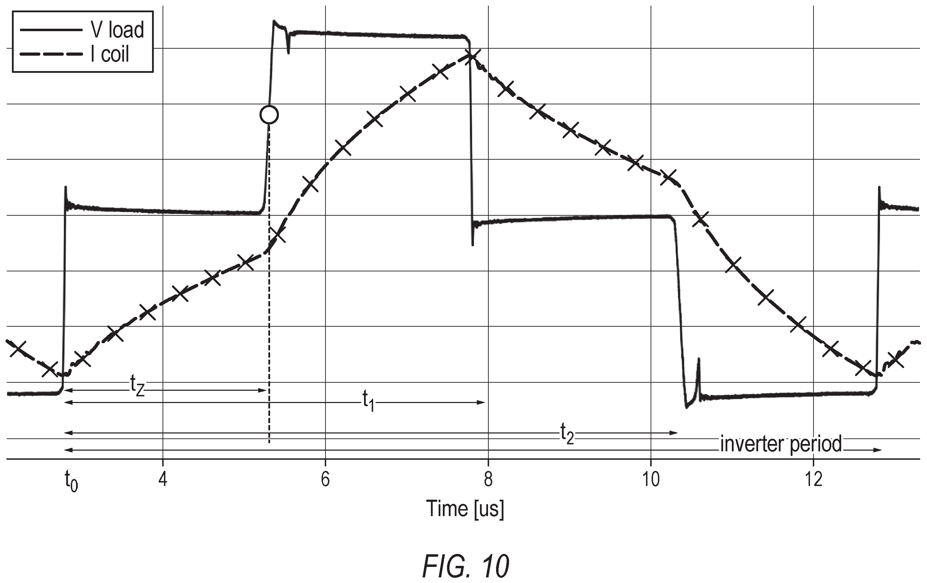

FIG. 10 illustrates a coil current and the voltage load during an inverter period with a phase shift of 90°;

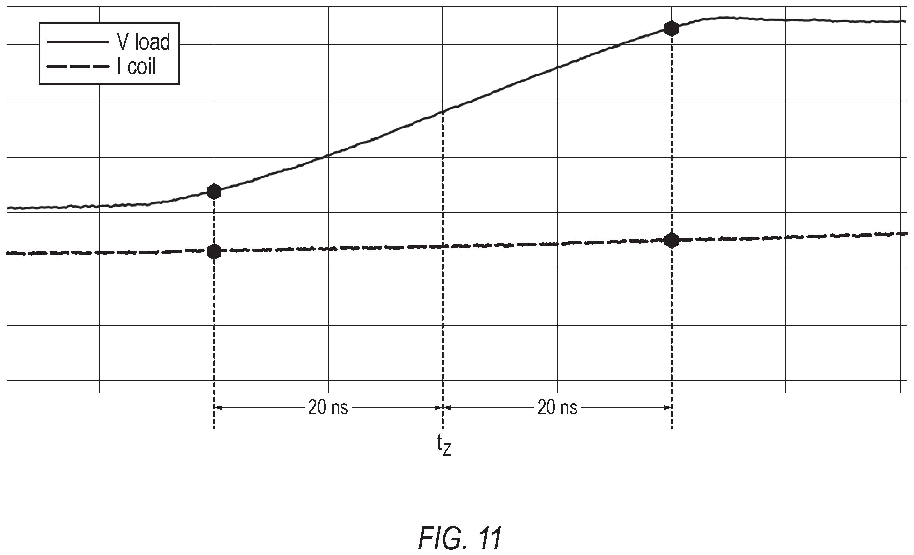

FIG. 11 illustrates a zoomed in portion of FIG. 10 during the transition period of the *V_{load}* from 0 to *V_{bus}* value;

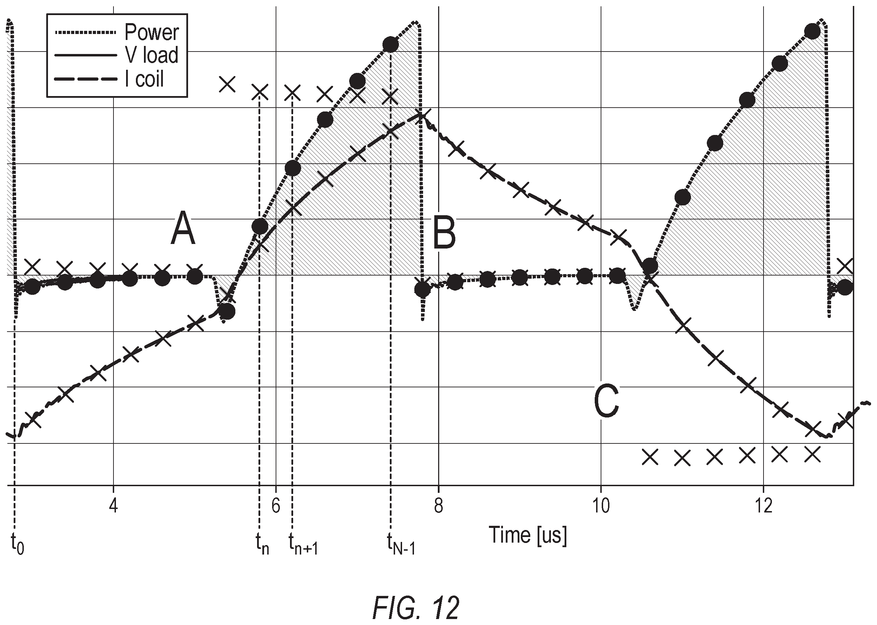

FIG. 12 illustrates an example waveform of the instantaneous power, coil current and load voltage; and

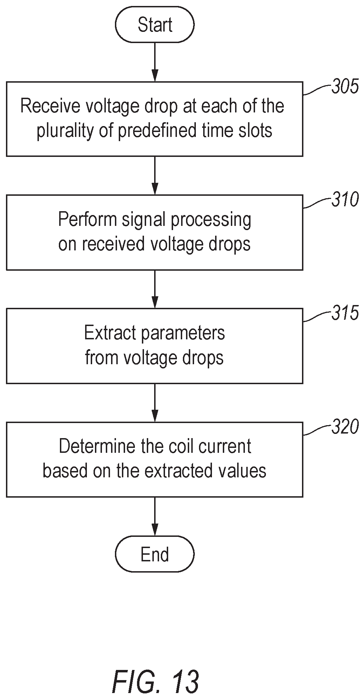

FIG. 13 illustrates a flow chart for an example process of the system described herein.

### DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

Cooktops or other induction cooking appliances include induction coils, often referred to as pancake coils due to their structure. When powered, these coils create a magnetic field, which in turn, can be used to heat up a cooking vessel or other cooking item formed of ferromagnetic material placed on the cooktop. The cooking item may be referred to herein as a load. When an alternating current (AC) passes through the winding, the current creates a magnetic field that induces an eddy current into the load, thus heating up the bottom of the load due to the Joule effect. During heating, it can be crucial to measure the alternating coil current provided by any inverter in the induction heating appliance. The power dissipated during heating is the square of the induced current times the equivalent resistance of the cookware. Therefore, a precise control of the current flowing in the coil is necessary in order to deliver the required power to the system. Moreover, measuring the current is necessary to ensure the protection of both the inverter and the coil. The maximum current may be limited by the maximum current of the inverter and the maximum current that can be supported by the coil cable. A threshold of current may be set as the minimum of these two maximum currents, usually the maximum current of the inverter. If the system passes this threshold, the system may go into a protection mode and stop the power delivery, or the system may reduce the current acting on frequency or phase shift.

Traditionally, the coil current is measured through a transformer connected in series with the coil and by reading the current flowing in the secondary winding of the transformer. However, this may lead to higher production costs and occupy space on the circuit board, imposing several layout constraints. Other solutions involve virtual sensing with control algorithms. Further, inverters used in induction heating appliances are typically quasi-resonant and resonant.

Disclosed herein is a method for measuring the AC current flowing in the coil using a low resistance resistor such as a shunt resistor, as well as a system for accurate reconstruction of the current waveform starting from the obtained measuring and using the shunt resistor. The system may include a full bridge inverter having the shunt resistor on one of the legs, or on both legs. The shunt resistor allows for cost-effective, space saving, magnetically immune, and highly accurately component to use for measuring current.

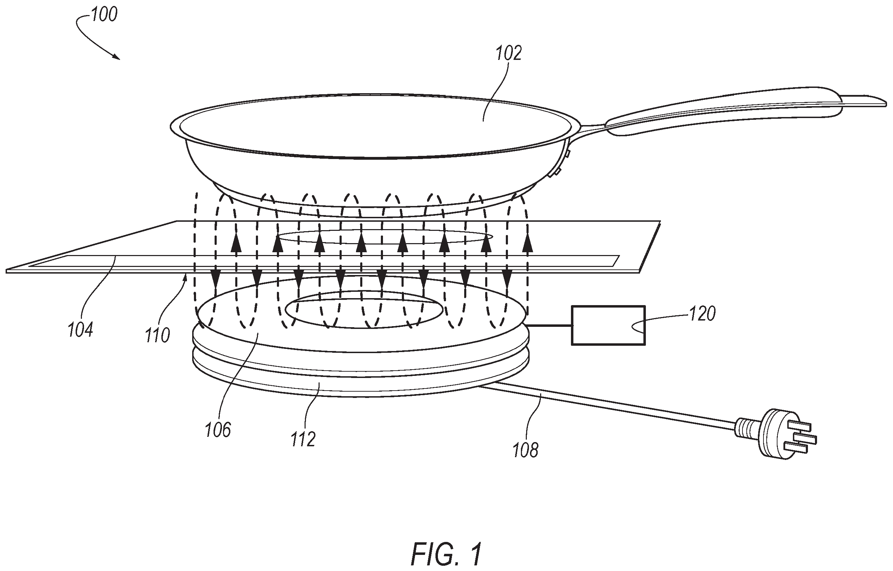

FIG. 1 illustrates a side view of an induction cooking system 100. The system 100 may be an induction cooktop configured to generate an electromagnetic field to rapidly and directly heat a load 102 placed thereon. The load may be any type of cooking vessel or other cooking item configured to conduct and withstand high heat, such as a pot, pan, griddle, etc. In the examples discussed herein, the load is made of metal, and more specifically a metal containing iron, such as a stainless-steel cooking item. However, other highly magnetic metals may additionally or alternately be used. The system 100 may include a cooktop surface 104 for receiving the load 102. The cooktop surface 104 may be formed of glass, ceramic, or another high-heat resistant surface.

An induction coil winding 106 is arranged below the cooktop surface 104. The induction coil 106 may be formed of copper or another material suitable for materials with good electrical conductivity (such as aluminum, copper-clad aluminum (CCA), or similar materials). The induction coil 106 is configured to receive electrical current from a power source 108. The power source 108 may supply high frequency AC by an electronic board, usually in a range greater than 18 kHz. The alternating current may generate a variable magnetic field 110 that causes electrons movements and vibration within the load bottom. The movements and vibrating of the electrons create heat on the load 102. The load 102 may then heat the contents of the load 102 through conductive heat.

The electromagnetic field 110 is converted into thermal energy directly, creating an efficient heating mechanism. Because of the direct conversion, the amount of heat generated may be effectively controlled by controlling the strength of the magnetic field. Further, because the load 102 is heated with a magnetic field, the cooktop surface 104 remains generally cool.

The electromagnetic field 110 may create eddy currents, which are loops of electrical current induced within conductors by a changing magnetic field in the conductor. Eddy currents flow perpendicular to the magnetic field and are generally proportional in magnitude to the magnetic field and the rate of change of flux. The eddy current creates a magnetic field that opposes the change in the magnetic field that created it and causes energy loss and heat.

During use, while the cooktop surface 104 may remain cool, the coil 106 may generate heat. The system 100 may include a shield 112 arranged below the coil winding 106 to disperse and prevent the coil winding 106 from becoming too hot. The shield 112 may structurally maintain the coil winding 106 within a cooktop assembly or cabinet. The shield 112 may reduce electromagnetic noise generated by the coil winding 106 and also acts as an electromagnetic barrier configured to block the eddy currents generated by coil winding 106.

As explained above, the load 102 may change and characterization of the load may be required. This is achieved by generating a sequence of frequencies that are actuated for at least one halfwave of the main line. The faster the characterization process is completed, the better the user experience.

Actuation of the coil winding 106 may be controlled by a controller 120 or processor. The controller 120 may include the machine controller and any additional controllers provided for controlling any of the components of the system 100. Many known types of controllers can be used for the controller 120. It is contemplated that the controller 120 is a microprocessor-based controller that implements control software and sends/receives one or more electrical signals to/from each of the various working components to implement the control software.

The controller 120 may also include or be coupled to a memory configured to include instructions and databases to carry out the systems and processes disclosed herein. The controller 120 may be programmed to instruct the excitation or switching frequencies and maintain various thresholds and factors in the memory.

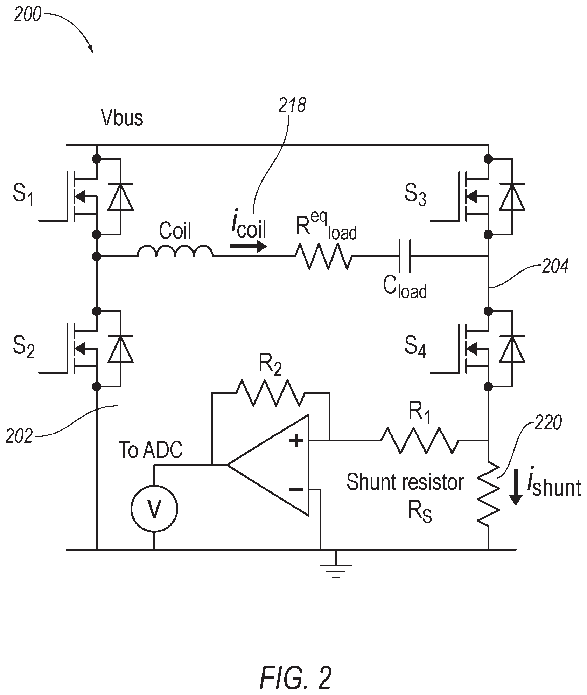

FIG. 2 illustrates an example full bridge inverter 200 having a shunt resistor 220. A full bridge inverter 200 is a type of circuit topology for converting direct current (DC) into alternating current (AC) by utilizing switches S arranged in two legs 202, 204. This configuration allows for the generation of an AC waveform by alternately switching current through the load in opposite directions. Specifically, the inverter 200 includes first leg 202 and second leg 204. The first leg 202 may include a first switch S₁ and a second switch S₂ connected in series while the second leg 204 may include a third switch S₃ and a second switch S₄. Both legs are connected to the same DCBUS voltage, created from the mains line. The inductive coil 106 is connected between the midpoint of the leg 202 (between switches S₁ and S₂) and at least one capacitor. The other side of the capacitor is connected to the midpoint of the leg 204 (between switches S₃ and S₄). In this way the load is formed by an RLC series circuit, where R is the equivalent resistance from the pot, L is the inductance of the coil and the pot, while C is the capacitor.

A resonant tank 218 is formed between the legs 202, 204 with the inductor and capacitor. The shunt resistor 220 may be arranged on the low side of one leg. In this example, the shunt resistor 220 is placed on the second leg 204. In this configuration, the current may be measured only where the fourth switch S₄ is closed.

The inverter 200 is supplied by a DC voltage *V_{bus}* obtained by rectifying the mains line. The inverter 200 operates in relation within a time interval and its temporal length is an integer multiple of the half mains line period, where the inverter performs measurements and executing commands based on the mains line half-way duration.

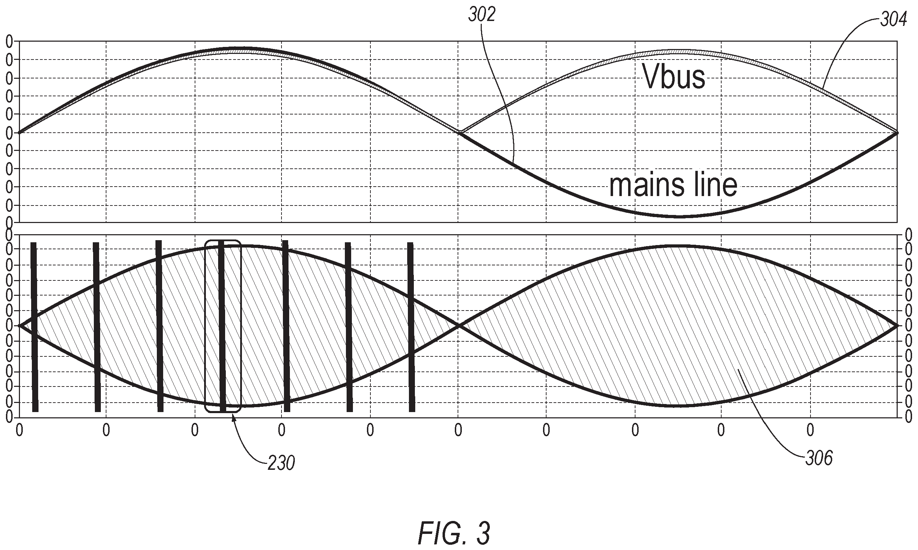

FIG. 3 illustrates the mains voltage 302, the DCBUS voltage 304 and the coil current 306 in a period of 20 ms, i.e. two halfwaves if the frequency is 50 Hz. The time slots 230 in which measurements are made a, including that of the coil current through the shunt resistor. 220. The mains line 302 has a period of 20 ms, in this example, and *V_{bus}* 304 has a period of 10 ms. The instant value of the current is measured by the voltage drop across the shunt resistor 220. This may be done through an Op Amp circuit, for example. The voltage output of the OP AMP is directly proportional with the current and can be read through an analog to digital converter (ADC) integrated in a microcontroller. In the examples discussed herein, the current is sampled during specific time slots 230. However, continuous sampling across the entire *V_{bus}* period may be obtained.

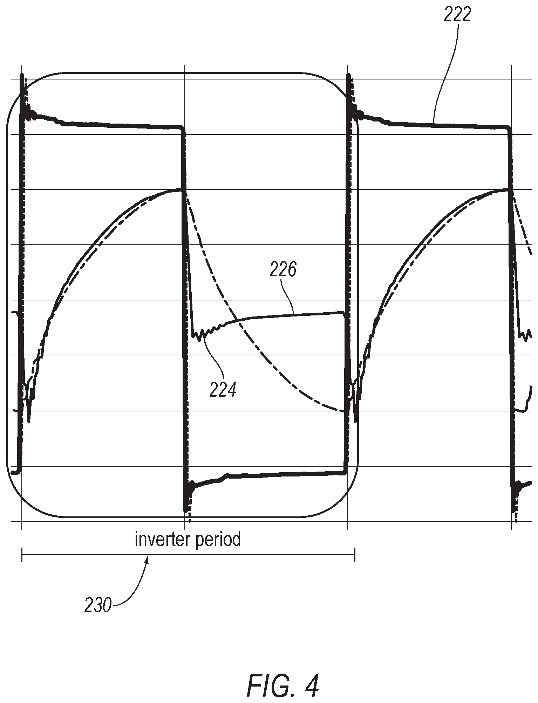

FIG. 4 illustrates one inverter period inside the time slots 230 at 50% of the *V_{bus}* period, i.e. at the center of the halfwave. In figure 4 load voltage waveform 222, the coil current waveform 224, and the shunt current waveform 226 are shown. The selected time slots where the current signal is sampled may be distributed during the *V_{bus}* period and the quantity of the time slots are selected based on a trade-off between the precision of the measurement process and the computation effort required by the controller 120. Once sampled, signal processing is applied to the data points and an analysis by the control results in synthetic values of the current for each time slot. These values may include the RMS or peak values, etc. The synthetic current, or current parameters of each time slot are successively used to perform aggregated signal analysis over the entire half-wave period in order to extract the characteristic parameters of the half-wave itself. Specifically, the voltage drop associated with each slot is not a single measurement, but a sequence of measured values.

The full-bridge inverter 200 operates in relation within a time interval and its temporal length is an integer multiple of the half mains line period. The inverter 200 performs measurements and executes commands based on the mains line half-wave duration. For implication of the discussion, this time interval is limited by two consecutive mains line voltage zero-crossing events, but the method illustrated can be used in any time interval with equivalent duration. The shunt solution offers cost-effectiveness, space-saving, magnetic immunity, and high accuracy. The shunts and its related circuit is less expensive than a transformer solution, thus lowering the cost of the entire system. Space saving also leads to reducing costs associated with the printed circuit board (PCB).

Due to constraints in the design of the inverter 200, certain signal processing steps are performed to reconstruct the coil current. In one example, the activation of the ADC sampling may be synchronized with the signal driving the switches. This may ensure that one of the samples acquired by the ADC is precisely sampled at the end of the inverter half-period. It is important to correctly sample the current signal aligned to the end of the inverter half-period, the point just before the voltage changes across the inductive coil. This sample allows the reconstruction of the signal at the end of the half-period but also at the beginning of the half-period due to signal symmetry. After this point, the coil current ceases to flow in the shunt resistor until the end of the switching period. Thus, knowing the sampling frequency of the ADC and the working frequency of the inverter, the ADC sampling can be synchronized.

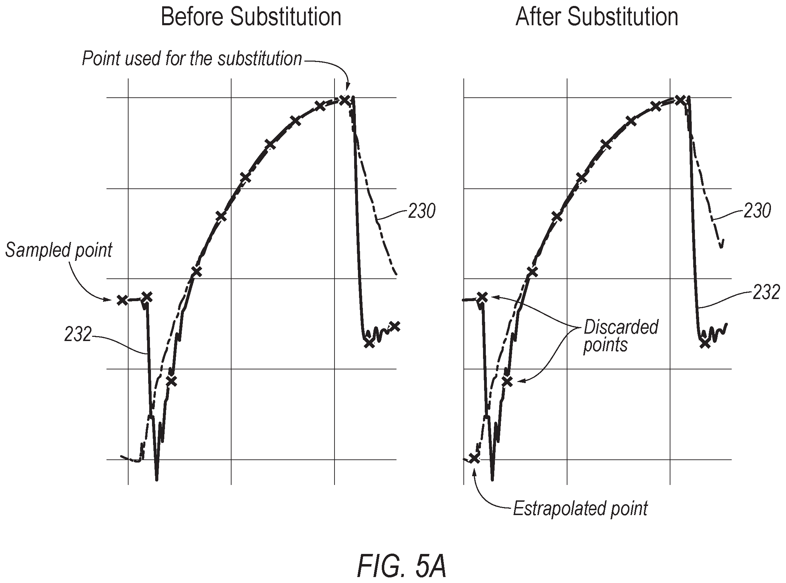

FIG. 5A illustrates an example of coil current measurement 230, coil current 232 measured through the shunt and the ADC samples (black crosses) before and after substitution of the initial samples over time. Due to electrical noise in power switching, the initial samples may be noisy. These samples may not accurately represent the current signal. Further, as the sampling initialization time is synchronized as described above, the very first sample may not be located exactly at the beginning of the period. To remedy this, the first sample is replaced with a sample taken at the end of the inverter half-period, mirrored along the x-axis, as illustrated in FIG. 5A.

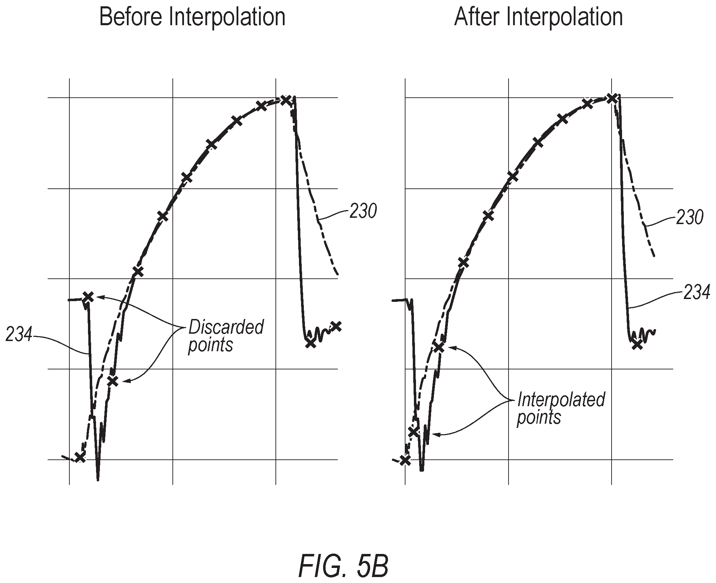

FIG. 5B illustrates example of coil current measurements 230, coil current 232 measured through the shunt and the ADC samples (black crosses) before and after interpolation over time. To further enhance the accuracy of the initial samples, linear interpolation may be used. An example function may include: $i \left(t\right) = \frac{{i}_{2} - {i}_{1}}{{t}_{2} - {t}_{1}} \left(t-{t}_{1}\right) + {i}_{1}$
where *i*(*t*) is the value of the current at time *t*;
*t* is any time instant in the acquisition interval;
*t*₁ = 0 is the time instant of the first sample;
*t*₂ is the time instant of the first noise-free sample;
*i*₁ is the value of the current of the first sample;
*i*₂ is the value of the current of the first noise-free sample.

The first noise-free sample depends on both the sampling frequency and the inverter frequency. In the worst-case scenario (maximum value for the inverter frequency), this sample is verified to be the fourth in sequence, so the interpolation function is employed to determine the values of the second and the third point as shown in FIG. 5B, starting from the substituted one.

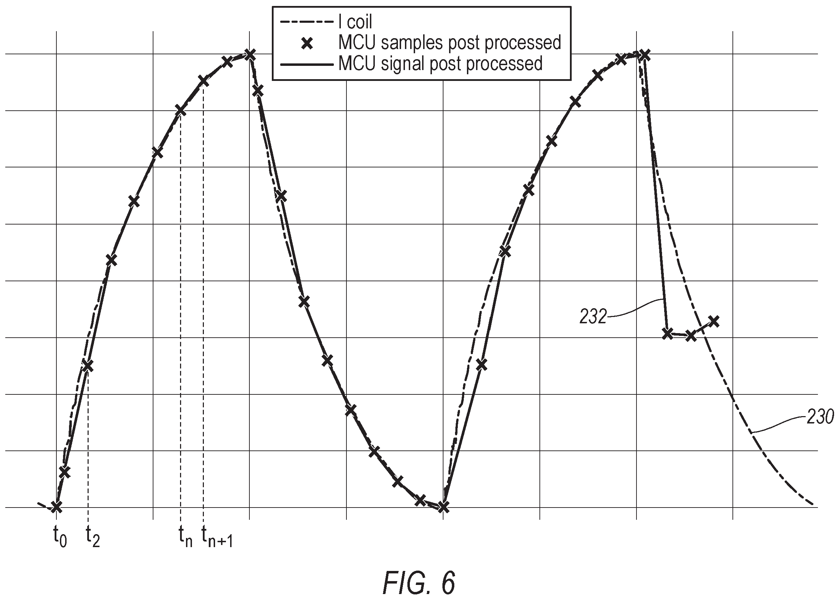

FIG. 6 illustrates a comparison between a measured coil current 230 and the reconstructed current 234 interpolated from the samples and post processing. After reconstructing the signal in the inverter first half-period, the second half-period can be obtained, due to the signal symmetry, by simply repeating and inverting the samples of the first half-period. The final result is illustrated in FIG. 6. The measured coil current may be measured using an oscilloscope.

Once the current signal has been extrapolated, the Root Mean Square (RMS) of the current for each time slot interval of the mains line half-wave is calculated. For a discrete set of current samples, *Iₙ*, where n is the sample index, and the corresponding time instants, *tₙ,* the RMS is calculated, using the trapezoidal integration method, as: ${I}_{RMS} = \sqrt{\frac{{\sum }_{n = 0}^{N - 1} \frac{1}{2} \left({I}_{n}^{2}+{I}_{n + 1}^{2}\right) ∗ \left({t}_{n + 1}-{t}_{n}\right)}{T}}$
Where,
*I_{RMS}* is the Root Mean Square current value;
*N* is the total number of samples within the selected interval;
*Iₙ* represents the current sample at index n;
*tₙ* is the corresponding timestamp of the current sample at index *n*; and
*T* is the total duration of the interval.

The trapezoidal rule is a numerical method for approximating the value of a definite integral. The rule includes dividing the area under the curve into trapezoids rather than rectangles and then summing their areas to approximate the integral.

Finally, the current RMS value over the entire mains line half-wave period is calculated using the RMS values calculated in the previous step in a new trapezoidal integration.

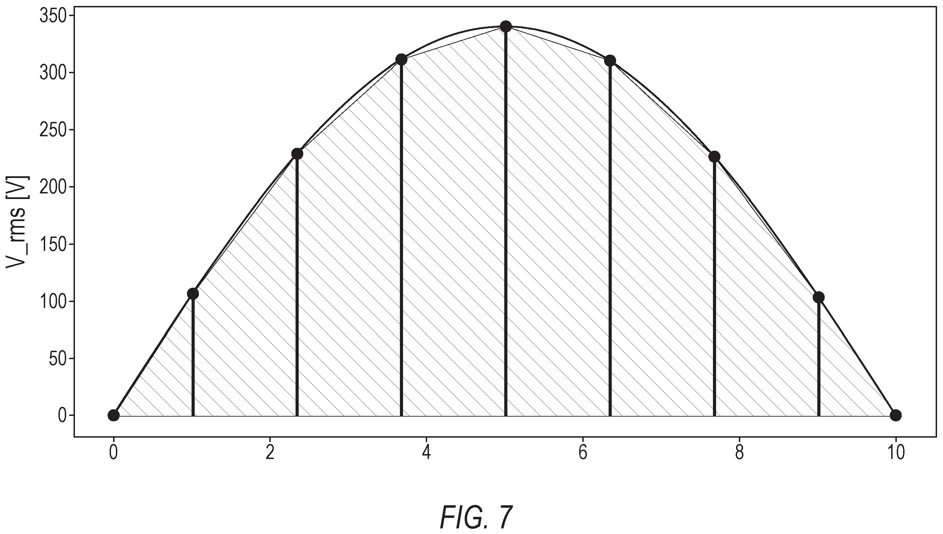

FIG. 7 illustrates a segmented period of *V_{bus}.* In this chart, for example, the period is segmented into seven slots, with measurements taken at each slot. For each slot, the RMS value of the current is determined, followed by application of the trapezoidal rule for numerical integration, in order to estimate the current average value over the period.

In addition to the current RMS calculation, the peak current value may also be determined. The peak value for each slot is obtained, and from these values the peak value in the entire mains line half-wave is determined, choosing the higher values among all the slot peak values.

Further to the above, measuring the power delivered to a cookware by any topology of an inverter for induction heating is important. Avoiding the use of a voltage sensor may decrease costs and simplify production. Typically, to measure the power delivered to the load, both the current flowing into the coil and the voltage of the resonant tank 218 are measured. The current measurement is obtained by a transformer placed in series with the load, obtaining a stable noiseless signal. The voltage may be measured via direct measurement using sensors, or indirect measurements involving the reconstruction of the voltage from the voltage supply or other electrical quantities of the circuit. The inverters traditionally used in IH application are quasi-resonant and half-bridge inverters.

Disclosed here is a system configured to calculate the average power delivered to by the inverter in a working period of the half bridge without the use of voltage sensors. Such calculations may be based on the inverter period, instantaneous current and load voltage for each sample. The system, via the controller 120, may also be configured to calculate the RMS of the voltage drop across the coil. Further, the system may calculate the average power via phase shifting techniques. While half-bridge inverters are described herein, full-bridge amplifiers may also be implemented.

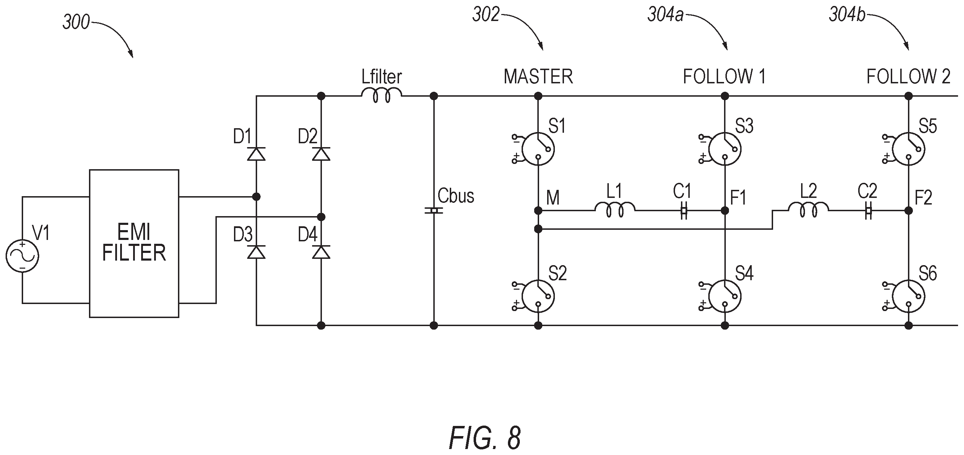

FIG. 8 illustrates a portion of a circuit 300 for controlling the operation of two cooking areas. The circuit 300 includes an ElectroMagnetic Interference (EMI) filter connected to the AC mains lines at V₁, and a rectifier circuit in order to have a *DC_{bus}* voltage (*V_{bus}*) to supply the inverter. Several half-bridges, or legs, may be connected in parallel to the *DC_{bus}.* The first half bridge 302 is the master and the second half bridge may be referred to as followers 304. The LC load for each slave inverter is connected between the master 302 and the respective follower 304. The master 302 forms a full-bridge inverter with each of the followers 304, where each follower 304 work separate from the others.

More specifically, FIG. 8 illustrates a master 302 and two followers 304a, 304b. In this example, the circuit requires three distinct PWM signals: one for the master 302, and another one for each of the followers 304a, 304b. Because the structure is a full bridge inverter, phase shifting may be applied, which includes a phase displacement between the PWM master signal and the PWM follower signal, in order to modulate the power delivered to the load. The phase shift is defined as the phase displacement between the corresponding switches of the master 302 and the follower branch being controlled. These switches, for the full-bridge inverter composed by the master and first follower, are S₁/S₂, and S₃/S₄, as identified in FIG. 8.

FIGs. 9A-E illustrates example circuit signals of voltage over time where the phase shift is 90 degrees between the PWM signals of S₁ and S₂, or S₃ and S₄ during operation of the circuit 300. Depending on the phase shifts, S₁ (S₂) and S₄ (S₃) may overlap for different time intervals. This may lead to different values of the average voltage across the load and of the coil current. Thus, the power delivered to the load changes as well.

FIG. 9A illustrates a gate signal applied to S₁ as measured during operation of the inverter. FIG. 9B illustrates a gate signal applied to S₂. FIG. 9C illustrates a gate signal applied to S₃. FIG. 9D illustrates a gate signal applied to S₄. FIG. 9E illustrates a voltage load and coil current during the inverter period.

Referring back to FIG. 3 and FIG. 4, the mains line with a period of 20ms is illustrated, and a *V_{bus}* with a 10ms period is also illustrated. As shown, the amplitude of the envelope of the coil current and the load voltage changes during the period, following the pattern of *V_{bus}.* This results in higher values at the center of the period and lower values at the extremities, which leads to the inverter having to work in accordance with the *V_{bus}* frequencies, synchronizing with it. The inverter operates in relation within a time interval that is an integer multiple of the *V_{bus}* period, during which it performs measurements and executes commands based on the bus duration. For one example and for explanation purposes, the time interval is limited by two consecutive mains line voltage zero-crossing events when the mains line crosses the x-axis. The method, however, can be used for any time interval with equivalent duration.

Referring back to FIG. 2, the shunt resistor 220 is arranged on the second leg 204 of the inverter 200. As explained, this shunt resistor 220 has an extremely low resistance, such as 0.5 mΩ, and is placed below the low side device of each follower leg and connected to an operational amplifier in order to measure the voltage across the shunt itself.

The voltage output of the Op Amp is directly proportional with the current flowing in the leg and can be read through an analog-to-digital converter (ADC) usually integrated in a microcontroller, which may also manage the sample storage. To avoid undue processing costs, samples of the current are taken during specific time slots and as shown in FIG. 7. In addition to the measurements and signal processing described with respect to FIGs. 3-7, the controller 120 may also take and determine other measurements.

In one example, the *V_{bus}* is measured through a resistor divider and an op amp. The voltage is reconstructed based on the voltage across the load starting from *V_{bus}.* The load voltage also depends on the trend of the PWM signals that control the master and the followers and can assume RMS values from zero to the maximum *V_{bus}* depending on the phase shift between S₁ and S₄, and S₂ and S₃. Specifically, the instantaneous load voltage *V_{load}* may be *+V_{bus}, -V_{bus},* and zero.

To determine and calculate the power delivered to the load, both voltage and current are used. The *V_{bus}* voltage and the coil current are sampled at the same time, in order to have synchronized values. Next, the real values of the voltage load is estimated based on when *V_{load}* is equal to *V_{bus}, -V_{bus},* or zero, starting from the phase shift with which the inverter is working.

FIG. 10 illustrates a coil current and the voltage load during an inverter period. The samples acquired by the ADC are illustrated as x's. *V_{load}* is not directly acquired by the controller 120, but is instead estimated as explained above.

The waveform of the coil current and the load voltage for an inverter working with a phase shift of 90 degrees is shown by way of example. This phase shift is used to illustrate that the inverter period starts at t₀ and corresponds with the transition from *-V_{bus}* to zero. The load voltage *V_{load}* remains zero for a time equal to t_{z}, then becomes *+V_{bus}* until t₁. The load voltage then translates from *+V_{bus}* to zero and maintains this value until t₂, where it returns to *-V_{bus}* until the end of the period. Thus, the period can be divided into two parts, one from t₀ to t₁, and a second part from t₁ to the end. This limits the analysis to the first half and since the second half is symmetrical to the first with respect to the x-axis, processing time can be shortened.

As illustrated, *V_{load}* changes its value only once at *t_{z}* during the first half. To obtain this value: ${t}_{z} = \left(1-\frac{PS}{180 °}\right) ∗ \frac{{T}_{i}}{2} + {t}_{0}$
Where:
*t_{z}* is the time instant for which the load voltage translates from zero to *V_{bus}*;
*PS* is the phase shift of the follower;
*Tᵢ* is the inverter period; and
*t*₀ is the time instant in which the inverter period starts.

This equation shows that *t_{z}* shifts from right to left as phase shift increases. The boundary cases are PS is 180°, i.e. the full-bridge inverter operates without the phase shift technique, with *t_{z}* equal to 0, and PS equal to 0°, where S₁ and S₃, or S₂ and S₄, are completely turned on in phase and then the voltage drop over the load is always zero. The instant of time *t_{z}* is important because it allows, by reading the array of the timestamps, to determine which voltage samples have the correct value (*V_{bus}*) and which have to be set to zero since the load voltage can't assume the *-V_{bus}* voltage.

FIG. 11 illustrates a zoomed in portion of FIG. 10 during the transition period from 0 to *V_{bus}.* In this example, *t_{z}* is taken as the point where the load voltage is equal to *V_{bus}*/2. The transition region has a duration of about 40ns.

The voltage transition from zero to *V_{bus}* at *t_{z}* is not instantaneous but depends on many factors which may include, for example, physical parameters of the switching devices. Because of this, it is advantageous to correctly estimate the voltage value in that region. To do this, two new voltage samples are used, one placed before, and one placed after *t_{z}*, at the ends of the transition zone. The length of the transition zone is obtained through empirical measurements. In the example in FIG. 11, the length of the transition zone is about 40ns. The values of the load voltage samples are instead fixed to zero and *V_{bus},* respectively. The result is illustrated in FIG. 11.

After these steps, the RMS value of the voltage across the load is reconstructed using the load voltage in a specific time slot of the mains line half-wave. Similar to the above, a trapezoidal integration over the time slot is performed using the voltage values and their timestamps. The formula is the following: ${V}_{load}^{RMS} = \frac{{\sum }_{n = 0}^{N - 1} \frac{1}{2} \left({V}_{n}^{2}+{V}_{n + 1}^{2}\right) ∗ \left({t}_{n + 1}-{t}_{n}\right)}{T}$
Where:
*V_{RMS}* is the Root Mean Square voltage value of the slot;
*N* is the total number of samples within the slot;
*Vₙ* represents the voltage sample at index;
*tₙ* is the corresponding timestamp of the voltage sample at index; and
*T* is the total duration of the interval.

These operations are performed for each time slot of the mains line half wave. In addition to the current measurement, the power may also be calculated.

Accordingly, the system generates an array with the RMS values of the coil current and an array with the RMS values of the *V_{load},* during each time slot. In addition to the method used to measure the current described above, in order to effectively estimate the power delivered to the load, two additional current samples are acquired, one before and one after t_{z}, as already described for the estimation of the load voltage. The values of the current samples are obtained through a linear interpolation between the two samples closest to the transition zone, as shown in FIG. 11.

Once this is done, the average power delivered by the inverter in the working period is determined. This is achieved by first determining the instantaneous voltage first by multiplying point-by-point between the elements of the current array and the elements of the voltage.

FIG. 12 illustrates an example waveform of the instantaneous power, coil current and load voltage. The shaded region represents the total delivered power where the circles and x's represent the samples acquired by the ADC. The Phase shift is 90 degrees. In this situation, the start of the inverter period is taken at the moment when the load voltage changes from *-V_{bus}* to zero (t₀). Thus, the period begins with negative coil current and zero load voltage: the power is zero. The coil current cannot immediately go to zero due to the reactive behavior of the inductor, and slowly begins to increase. However, before the coil current becomes zero, the voltage across the load becomes positive, indicated in FIG. 12 as transition A. Thus, the power from this instant forward is now different from zero because both current and voltage are not zero, aside from the time instant in which the coil current crosses the x-axis, in which the power is equal to zero.

Until the voltage remains *+V_{bus},* the power increases and it is different from zero. When the voltage returns to zero, as indicated as transition B in FIG. 12, the power returns to zero and the coil current begins to decrease. After, the load voltage changes to *-V_{bus},* indicated by transition C, and then the power returns to non-zero because both current and voltage are not zero, again, aside from the time instant in which the coil current crosses the x-axis, in which the power is equal to zero. Then, the load voltage translates from *-V_{bus}* to zero and the inverter period ends.

Having the instantaneous power, it is possible to obtain the average power delivered during the inverter period. A trapezoidal interpolation is performed to provide a more precise measure. This is achieved by: $P = \frac{1}{2} ∗ \frac{2}{{T}_{i}} ∗ {\sum }_{n = 0}^{N - 1} \left({i}_{n}∗{v}_{n}\right) ∗ \left({t}_{n + 1}-{t}_{n}\right)$
Where:
*tₙ* is the timestamp of the n-th sample;
*t*_{*n*+1} is the timestamp of the n-th + 1 sample;
*iₙ* is the instantaneous current of the n-th sample;
*vₙ* is the load voltage of the n-th sample;
*Tᵢ* is the inverter period; and
P is the average power dissipated over period *Tᵢ*.

FIG. 13 illustrates a flow chart for an example process of the system described herein. The process 300 may be performed by the controller 120 as explained herein or any other controller 120 or processor. The process 300 may begin at block 305 where the controller 120 may receive a voltage drop at each of a plurality of predefined time slots.

At block 310, the controller 120 performs signal processing on each of the received voltage drops in order to extract characteristic parameters of the signal. Examples of the parameters may include the RMS and peak value of the voltage load and coil current, though other examples may be appreciated.

At block 315, the controller 120 extracts the parameters from the voltage drop signals.

At block 320, the controller 120 determines the coil current based on the extracted values. This may include applying the trapezoidal rule to estimate the current average value over a specific period. Other processing that may be used in determining the coil current include synchronizing the sample current signal at a known frequency, substituting a first sample with a sample taken at the end of the inverter half period, interpolating the replaced sample, reconstructing the second half period based on signal symmetry with the first half-period, as well as calculating the RMS of the current for each time slot interval.

At block 320, the controller 120 calculates the average power delivered to the inverter. This may be done in the working period without the use of the voltage sensors, based on the inverter period instantaneous current and load voltage for each sample. The RMS of the voltage drop may be determined across the coil.

The process 300 may then end.

Accordingly, disclosed herein is an inverter for providing current to an induction cooktop, where the inverter includes a shunt resistors arranged on a low side of the inverter. A controller 120 may use the voltage drop across the shunt resistor to determine the coil current. The voltage drop may be measured at predefined time slots and the controller 120 is programmed to perform signal processing on the voltage drop at each time slot to extract characteristic parameters of the signal, such as the RMS and peak value of the coil current to determine the coil current.

Further, the controller may be further programmed to synchronize the sample current signal at a known frequency, substitute a first sample with a sample taken at the end of the inverter half period, interpolate the replaced sample, reconstruct the second half period based on signal symmetry with the first half-period, as well as calculate the RMS of the current for each time slot interval.

The system may also calculate the average power delivered by the inverter in the working period without the use of the voltage sensors, based on the inverter period instantaneous current and load voltage for each sample. The RMS of the voltage drop may be determined across the coil.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

Computing devices described herein generally include computer-executable instructions, where the instructions may be executable by one or more computing or hardware devices such as those listed above. Computer-executable instructions may be compiled or interpreted from computer programs created using a variety of programming languages and/or technologies, including, without limitation, and either alone or in combination, Java^{™}, C, C++, Visual Basic, Java Script, Perl, etc. In general, a processor (e.g., a microprocessor) receives instructions, e.g., from a memory, a computer-readable medium, etc., and executes these instructions, thereby performing one or more processes, including one or more of the processes described herein. Such instructions and other data may be stored and transmitted using a variety of computer-readable media.

## Claims

1. A method for estimating coil current for an inductive cooking appliance, comprising:
receiving a multiplicity of measured voltage drops for each of a predetermined inverter period across a shunt resistor arranged on a low side of an inverter;
extract at least one of a root mean square (RMS) and a peak voltage for the multiplicity of voltage drops received during a predetermined inverter period; and
determine a coil current based on the extracted at least one of the RMS and peak voltages.

2. The method of claim 1, further comprising determining a multiplicity of sample current signals based on the multiplicity of voltage drops.

3. The method of claim 2, further comprising calculating an average power based on the inverter period and/or the multiplicity of sample current signals and/or a time slot and/or a load voltage.

4. The method of claim 3, wherein the time slot is a predefined time interval larger than the inverter period.

5. The method of claim 4, wherein the load voltage is voltage drop across a resonant tank connected to the inverter.

6. The method of any of claims 2-5, further comprising synchronizing a first sample of the multiplicity of sample current signals with a predefined time difference relative to an end of an inverter half-period.

7. The method of claim 6, wherein the predefined time difference can be one of positive or negative.

8. The method of claim 6 or claim 7, further comprising substituting the first sample current signal with a later acquired sample current signal.

9. The method of claim 8, further comprising interpolating at least one of the samples in the multiplicity of sample current signal, excluding the substituted sample current signal, using at least the substituted sample current signal.

10. The method of any of claims 6-9, further comprising reconstructing the measured and estimated signals in a second half-period based on signal symmetry with a first half-period through the inverter.

11. The method of any preceding claim, wherein the extracted at least one of the RMS and peak voltages is achieved via signal processing.

12. A system for estimating coil current for an inductive cooking appliance, comprising:
an inverter having a high side and a low side;
a shunt resistor arranged on a low sides of the inverter;
a resonant tank connected to the inverter;
a controller programmed to
receive a multiplicity of measured voltage drops for each of a predetermined inverter period time slot across a shunt resistor arranged on a low side of an inverter;
extract at least one of a root mean square (RMS) and a peak voltage for the multiplicity of voltage drops received during a predetermined inverter period each received voltage drop; and
determine a coil current based on the extracted at least one of the RMS and peak voltages.

13. The system of claim 12, wherein the controller is further programmed to determine a multiplicity of sample current signals based on the multiplicity of voltage drops.

14. The system of claim 13, wherein the controller is further programmed to calculate an average power based on the inverter period and/or the multiplicity of sample current signals and/or a time slot and/or a load voltage.

15. The system of any of claims 12-14, wherein the extracted at least one of the RMS and peak voltages is achieved via signal processing.
